# EUROPÄISCHE PATENTSCHRIFT

(11) **EP 0 782 003 B1**
(45) Veröffentlichungstag und Bekanntmachung des Hinweises auf die Patenterteilung: **20.04.2005**
(21) Anmeldenummer: 96118415.7
(22) Anmeldetag: 16.11.1996
(51) Int. Cl.: G01R 29/08

(54) **Vorrichtung zur EMV-Prüfung von elektrischen Geräten**
Means for EMC-testing electrical appliances
Dispositif pour tester le CEM d'appareils électriques

(30) Priorität: 29.12.1995 DE 19549134
(43) Veröffentlichungstag der Anmeldung: 02.07.1997
(73) Patentinhaber: Rohde & Schwarz GmbH & Co. KG, 81671 München (DE)
(72) Erfinder: Danzeisen, Klaus, Dipl.-Ing., 82166 Gräfelfing (DE); Göpel, Klaus-Dieter, Dr. rer.nat., 80997 München (DE); Schmidt, Werner, Dr. Ing. habil, 09122 Chemnitz (DE)
(74) Vertreter: Körfer, Thomas, Dipl.-Phys.

(56) Entgegenhaltungen:
- EP-A- 0 780 693
- WO-A-93/03387
- ELECTRONICS LETTERS, 7.November 1996, Seiten 2127-2128, XP000643858
- CARBONINI L.: 'A shielded multi-wire transmission line for susceptibility measurements with horizontally polarized electric field' IEEE, EIGHTH INTERNATIONAL CONFERENCE ON ELECTROMAGNETIC COMPATIBILITY 1992, Seiten 33 - 38, XP001152427

## Beschreibung

Die Erfindung betrifft eine Vorrichtung zur EMV-Prüfung von elektrischen Geräten.

Vorrichtungen dieser Art zur EMV- (Elektromagnetische Verträglichkeit) bzw. EMI-(Elektromagnetic Interference) Messung sind bekannt. Das elektromagnetische Feld in der Kammer wird bei den bisher benutzten Vorrichtungen durch ein unsymmetrisches Erregersystem erzeugt, bei dem die metallische Kammer den Außenleiter und eine isoliert in der Kammer gehaltene Metallplatte den Innenleiter eines Koaxialleitungssystems bildet, das unsymmetrisch aus einer Hochfrequenzquelle gespeist ist (DE 39 31 449, DE 31 30 487, DE 39 25 247, DE 37 31 165,

DE 43 00 778, EP 0 517 992, Wunderlich, Werner: Störfestigkeitsmessungen an Einrichtungen zur drahtlosen Nachrichtenübertragung mit relativ großen Abmessungen, Technische Mitteilungen des RFZ, 28. Jg., H. 1, 1984, S. 20 ff; Crawford, M.L., Workman, J.L. Thomas, C.L.:"Generation of EM susceptibility Test Fieldes Using a Large Absorber-Loaded TEM Cell", IEEE-Transactions on Instrumentation and Measurement, Sept. 1977, Nr. 3, Seiten 225 ff). Um hierbei die von der EMV-Norm vorgegebene gleichmäßige Feldstärkeverteilung in der Kammer zu erzielen (die Norm verlangt, daß die Feldstärkeänderung im Prüfraum kleiner als 6 dB ist), muß die Innenleiterplatte, auf welcher der Prüfling abgestellt wird, möglichst in der Kammermitte angeordnet werden, dadurch steht aber nur der halbe Raum der Kammer für die Aufnahme des Prüflings zur Verfügung. Außerdem sind die die Norm erfüllenden EMV-Prüfvorrichtungen sehr voluminös, da für den Übergang vom koaxialen Speisekabel zu dem das Feld erzeugenden Innenleiter/Außenleiter-System eine pyramidenförmige Kammerausbildung erforderlich ist.

Es wurde zwar schon versucht, den Innenleiter möglichst nahe an der unteren Bodenwand einer quadratischen Kammer anzuordnen (G-STRIP-Zelle Comtest der Firma Thermo Voltek, Großbritannien), dadurch wird zwar der nutzbare Raum für die Aufnahme des Prüflings vergrößert, diese bekannte Zelle erfüllt jedoch nicht die strenge Norm für die gleichmäßige Feldstärkeverteilung in der Kammer.

Zur EMI-Messung von Großobjekten wie Flugzeuge wurde auch schon vorgeschlagen, in einem großen Abstand von beispielsweise 20 Metern parallel zueinander zwei aus mehreren parallelen Leitern bestehende Leiterfelder anzuordnen, die zusammen eine symmetrische Doppelleitung (Lecherleitung) bilden (L. Carbonini "A SHIELDED MULTI-WIRE TRANSMISSION LINE FOR SUSCEPTIBILITY MEASUREMENTS WITH HORIZONTALLY POLYRIZED ELECTRIC FIELD", 8. Internationale Konferenz "Electromagnetic Compatibility", 21. - 24. September 1992, Seiten 33 bis 38). Die Leiter dieser symmetrischen Doppelleitung werden am einen Ende aus einer Hochfrequenzquelle über einen Impedanztransformator gegenphasig gespeist, am anderen Ende sind diese Leiter der Doppelleitung jeweils über verteilte Widerstände abgeschlossen. Diese symmetrische Doppelleitung ist außen mittels einer durch Leiterfelder gebildeten Abschirmung abgeschirmt, um so die Fernfeldabstrahlung zu reduzieren. Diese Abschirmung ist elektrisch nicht mit der symmetrischen Doppelleitung verbunden, sondern von dem Speisesystem bzw. den Abschlußwiderständen elektrisch isoliert.

Gleiches gilt für die Vorrichtung zum Prüfen der elektromagnetischen Verträglichkeit gemäß der nicht vorveröffentlichten Schrift EP 0 780 693 A2, bei der eine als TEM-Wellenleiter ausgebildete Zelle um den Prüfling herum gedreht wird. Auch hier sind innerhalb der Zelle in einem geringen Abstand zu dem elektrisch leitenden Deckel und Boden der Zelle jeweils flächige Septen angeordnet, die aus einzelnen Drähten gleicher Länge bestehen und die an den Enden über Ablußwiderstände mit dem elektrisch leitenden Deckel bzw. Boden verbunden sind. Die Septen bilden wieder eine symmetrische Doppelleitung, die aus einem Generator über einen Symmetrieübertrager gegenphasig gespeist ist. Auch hier fehlt eine elektrische Verbindung zwischen dem Symmetrieübertrager und den Wänden der Zelle, die Zellenwände wirken daher auch hier nur als Abschirmung.

Es ist Aufgabe der Erfindung, eine EMV-Prüfvorrichtung zu schaffen, die bei minimalstem Platzbedarf einen größtmöglichen nutzbaren Prüfraum bietet und trotzdem die nach der Norm vorgeschriebene gleichmäßige Feldstärkeverteilung in der Kammer gewährleistet.

Diese Aufgabe wird durch eine Vorrichtung laut Hauptanspruch gelöst. Vorteilhafte Weiterbildungen ergeben sich aus den Unteransprüchen.

Bei der erfindungsgemäßen Vorrichtung wird das elektromagnetische Feld in der Kammer durch eine symmetrisch gegen das Kammergehäuse gespeiste Doppelleitung (Lecher-Leitung) erzeugt, deren Leiter einerseits in einem relativ großen und durch die Höhe der Kammer gebildeten gegenseitigen Abstand, jedoch in relativ geringem Abstand von den jeweils benachbarten Kammerwänden angeordnet sind. Dadurch wird das Kammergehäuse elektrisch mit in das Speisesystem für die symmetrische Doppelleitung einbezogen. Da sowohl der Symmetrierübertrager als auch die Abschlußwiderstände mit dem Kammergehäuse als Masse elektrisch verbunden sind, dient das Kammergehäuse jeweils elektrisch als Stromrückleitung. Das Kammergehäuse wird nicht nur als einfache Abschirmung benutzt, sondern so mit der symmetrischen Doppelleitung elektrisch kombiniert, daß ein sehr gleichmäßiges elektromagnetisches Feld in der Kammer entsteht. Durch die Nähe der Kammerwände baut sich auch außerhalb der Doppelleitung, also zwischen den Leitern und der Kammerwand, ein elektromagnetisches Feld auf. Dieses zwischen jedem Leiter und der benachbarten metallischen Kammerwand gebildete Leitungssystem kann als unsymmetrische Streifenleitung (Microstrip) betrachtet werden und es kann für dieses Streifenleitungssystem jeweils nach den hierfür bekannten Bemessungsvorschriften (Abstand des Leiters von der Kammerwand, Durchmesser bzw. Breite des Leiters und gegebenenfalls zwischen Leiter und Kammerwand vorhandenes Dielektrikum) der Wellenwiderstand berechnet werden, durch den auch der Wert des Abschlußwiderstandes zwischen Leiter und Kammerwand bestimmt ist. Die Feldstärkekonzentration im Raum zwischen Leiter u nd Kammerwand wird für die EMV-Messung nicht genutzt, sondern nur das elektromagnetische Feld im Raum zwischen den beiden gegenüberliegenden Leitern des relativ hochohmigen Doppelleitungssystems, das mit der nach der Norm erforderlichen gleichmäßigen Verteilung für die Prüfung zur Verfügung steht. In einem praktischen Ausführungsbeispiel ist die Änderung des elektromagnetischen Feldes in der gesamten Kammer nur ±3 dB. Trotzdem steht nahezu der gesamte Innenraum der Kammer für die Aufnahme von Prüflingen zur Verfügung und eine erfindungsgemäße Vorrichtung kann mit minimalsten äußeren Gesamtabmessungen hergestellt werden.

Im einfachsten Fall wird das Doppelleitungssystem nur durch zwei gegenüberliegende einzelne Leiter gebildet, es hat sich jedoch gemäß einer Weiterbildung der Erfindung als vorteilhaft erwiesen, auf jeder Seite mehrere nebeneinander angeordnete Leiter vorzusehen, die auf einer Seite der Kammer jeweils gleichphasig gespeist sind und so auch eine gleichmäßige Feldverteilung über die gesamte Kammerwand gewährleisten. Diese einzelnen nebeneinander angeordneten Leiter sind vorzugsweise parallel zueinander angeordnet, was jedoch nicht zwingend ist, sie könnten auch beispielsweise fächerförmig von einem zentralen Speisepunkt aus über die Kammerwand verteilt sein.

Bei mehreren nebeneinander angeordneten Leitern ist jeder über einen gesonderten Abschlußwiderstand gegen Masse (Kammerwand) abgeschlossen, die Summe all dieser Abschlußwiderstände der Doppelleitung entspricht dem Wellenwiderstand des Streifenleitungssystems. Die Doppelleitung besitzt auf diese Weise nicht mehr den relativ hochohmigen Wellenwiderstand, der sich bei einer üblichen Doppelleitung im freien Raum ausbilden würde, sondern ist durch den wesentlich geringeren Wellenwiderstand der Streifenleitungssysteme bestimmt, damit ist auch eine günstigere niederohmige eingangsseitige Einspeisung möglich. Durch unterschiedliche Dimensionierung der Abschlußwiderstände der einzelnen nebeneinander angeordneten Leiter ist es außerdem möglich, eine gewünschte spezielle Feldverteilung innerhalb der Kammer zu erzeugen, auf diese Weise kann beispielsweise in den Ecken der Kammer durch entsprechende Dimensionierung der dort wirksamen Abschlußwiderstände eine Feldverteilungsoptimierung erzielt werden. Gleiches ist durch unterschiedliche Wahl der gegenseitigen Abstände der Leiter je Leitergruppe möglich. Anstelle von jeweils getrennten Abschlußwiderständen für die einzelnen nebeneinander angeordneten Leiter könnten diese auch am Abschlußende wie bei der eingangsseitigen Speisung in einem Punkt über gleich lange Leitungen zusammengefaßt und über einen gemeinsamen Abschlußwiderstand gegen Masse geschaltet sein.

Um störende Reflexionen insbesondere im höheren Frequenzbereich zu vermeiden können auf den Innenwänden der Kammer auch noch entsprechende HF-Absorber angebracht sein, beispielsweise an den Stirnseiten, zwischen denen die Leiter der Doppelleitung angeordnet sind.

Im allgemeinen ist es für eine gleichmäßige Feldverteilung ausreichend, nur auf zwei gegenüberliegenden Kammerwänden die Leiter einer Doppelleitung anzuordnen, für spezielle Anwendungsfälle kann es jedoch auch zweckmäßig sein, an drei oder vier Seiten der Kammer jeweils solche Doppelleitungssysteme anzubringen, also beispielsweise am Boden und der Decke der Kammer ein erstes Doppelleitungssystem und an den gegenüberliegenden Seitenwänden ein zweites Doppelleitungssystem.

Die Erfindung wird im folgenden anhand schematischer Zeichnungen an einem Ausführungsbeispiel näher erläutert.

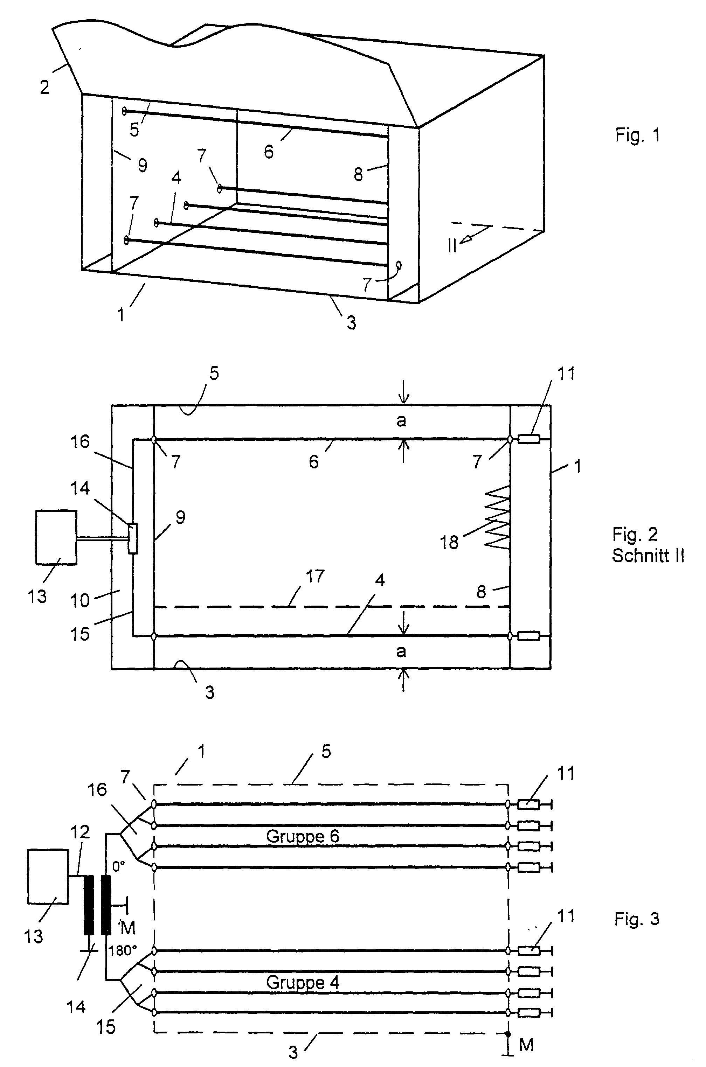

Fig. 1 zeigt perspektivisch die Gesamtansicht einer erfindungsgemäßen EMV-Prüfzelle mit einer quaderförmigen Kammer 1 aus Metallblech mit einer Seitenlänge von beispielsweise 1 bis 2 Meter zur Aufnahme eines nicht dargestellten elektrischen Gerätes, dessen elektromagnetische Empfindlichkeit nach der EMV-Norm gemessen werden soll. Die eine Seitenwand der Kammer 1 ist als Klapptür 2 ausgebildet. Am Boden der Kammer sind im Abstand a und parallel zur Bodeninnenwand 3 mehrere, im Ausführungsbeispiel vier Leiter 4 angeordnet und an der Kammerdecke in gleicher Weise im Abstand a parallel zur Deckeninnenseite 5 mehrere Leiter 6, wie das Schnittbild nach Fig. 2 zeigt. Die Leiter 4, 6 sind beispielsweise als Drähte ausgebildet, die zwischen Durchführungen 7 aus Isoliermaterial gespannt sind, die an stirnseitigen Zwischenwänden 8, 9 der Kammer befestigt sind. Falls erforderlich, können zwischen den Kammerwänden 3, 5 und den Leitern 4, 6 auch noch zusätzliche Isolierstützen angeordnet sein. Die Leiter 4, 6 werden, wie das Prinzipschaltbild nach Fig. 3 zeigt, am einen Ende über eine Speiseanordnung 10 mit gegenseitiger 180°-Phasenverschiebung gespeist und ihr anderes Ende ist jeweils über einen Abschlußwiderstand 11 mit den metallischen Kammerwänden (Masse M) verbunden. Die Speiseanordnung 10 ist beispielsweise über ein Koaxialkabel 12 mit einem Hochfrequenzsender 13 verbunden, über den in der Kammer ein elektromagnetisches Feld mit einer Frequenz beispielsweise zwischen 80 MHz und 1 GHz erzeugbar ist. Die über das Koaxialkabel 12 unsymmetrisch zugeführte Hochfrequenzleistung wird über einen Symmetrierübertrager 14 in der Speiseanordnung 10 gegen Masse M symmetriert und dann über eine Verteilerschaltung 15 bzw. 16 mit gleich langen Verteiler-Leitungen den einzelnen Leitern 4 bzw. 6 zugeführt. Die beiden gegenüberliegenden Leitergruppen 4, 6 bilden elektrisch eine symmetrische Doppelleitung, die aus dem Symmetrierübertrager 14 gegenphasig und symmetrisch gegen Masse M (Kammer 1) gespeist ist. Gleichzeitig bildet jede Leitergruppe 4 bzw. 6 mit der ihr gegenüberliegenden Kammerwand 3 bzw. 5 ein unsymmetrisches Leitungssystem, dessen Wellenwiderstand im wesentlichen durch den Abstand a der Leiter gegenüber der Kammerwand bestimmt ist. Die Abschlußwiderstände 11 sind entsprechend diesem Wellenwiderstand des unsymmetrischen Leitungssystems dimensioniert. Der Wellenwiderstand der Doppelleitung 4, 6 ist infolge des relativ großen gegenseitigen Abstandes - bestimmt durch die Größe der Kammer - relativ groß in der Größenordnung von mehreren KΩ während der Wellenwiderstand der unsymmetrischen Leitungssysteme 3, 4 bzw. 5, 6 in der Größenordnung von 50 bis 200 Ω liegt. Durch das funktionelle Zusammenwirken dieses symmetrischen Speisesystems mit den unsymmetrischen Leitungssystemen wird also die Doppelleitung mit relativ niederohmigen Abschlußwiderständen (Wellenwiderstand der Streifen-leitung) abgeschlossen und der parallel dazu liegende relativ hochohmige Wellenwiderstand der Doppelleitung kann bei der Dimensionierung des Abschlusses vernachlässigt werden. Eingangsseitig wirken die dem Wellenwiderstand der Streifenleitung entsprechenden Abschlußwiderstände in Reihe und bilden einen für die Speisung günstigen ebenfalls relativ niederohmigen Eingangswiderstand. Auf diese Kombinationswirkung ist die extrem gleichmäßige Feldstärkeverteilung innerhalb der Kammer zurückzuführen.

Die Abschlußwiderstände 11 sind vorzugsweise im Raum zwischen der stirnseitigen Zwischenwand 8 und der Stirnwand der Kammer 1 angeordnet, die Speiseanordnung 10 in dem Raum zwischen der stirnseitigen Zwischenwand 9 und der Kammerwand auf der gegenüberliegenden Seite.

Über der Leitergruppe 4 ist vorzugsweise noch ein schematisch angedeuteter Zwischenboden 17 zum Abstellen der Prüflinge vorgesehen.

Um störende Reflexionen insbesondere im höheren Frequenzbereich zu vermeiden können auf der Innenseite der Kammerwände noch zusätzliche HF-Absorber 18 angebracht sein, wie dies schematisch auf der Stirnzwischenwand 8 dargestellt ist. In gleicher Weise können auf der speiseseitigen Stirnwand 9 und gegebenenfalls auch auf den Seitenwänden entsprechende Absorber angebracht werden.

## Patentansprüche

1. Vorrichtung zur EMV-Prüfung von elektrischen Geräten, umfassend:
a) eine Kammer (1) aus leitendem Material;
b) mindestens zwei auf gegenüberliegenden Seiten der Kammer (1) im relativ geringen Abstand (a) parallel zu den Kammerwänden (3, 5) angeordnete Leiter (4, 6), die zusammen eine symmetrische Doppelleitung bilden;
c) eine Hochfrequenzquelle (13), aus welcher die beiden Leiter (4, 6) der symmetrischen Doppelleitung am einen Ende über einen Symmetrierübertrager (14) gegenphasig und symmetrisch gegen das Kammergehäuse (1) als Masse (M) gespeist sind;
d) wobei die Leiter (4, 6) der symmetrischen Doppelleitung an ihrem anderen Ende über Abschlußwiderstände (11) mit dem Kammergehäuse (1) elektrisch verbunden sind und mit den Kammerwänden (3, 5) jeweils unsymmetrische Leitungen bilden.

2. Vorrichtung nach Anspruch 1, **dadurch**
**gekennzeichnet, daß** die Abschlußwiderstände (11) so dimensioniert sind, daß sie dem zwischen den Kammerwänden (3, 5) und den Leitern (4, 6) gebildeten Wellenwiderstand entsprechen.

3. Vorrichtung nach Anspruch 1 oder 2, **dadurch**
**gekennzeichnet, daß** auf jeder Seite der Kammer (1) im Abstand parallel zur Kammerwand (3, 5) jeweils mehrere gleichphasig gespeiste Leiter (Gruppe 4 Bzw. Gruppe 6) nebeneinander angeordnet sind.

4. Vorrichtung nach einem der Ansprüche 1 bis 3,
**dadurch gekennzeichnet, daß** die gegenseitigen Abstände der Leiter (4, 6) und/oder die Abschlußwiderstände (11) im Sinne einer vorbestimmten Feldstärkeverteilung unterschiedlich dimensioniert sind.

5. Vorrichtung nach einem der vorhergehenden Ansprüche,
**dadurch gekennzeichnet, daß** auf der Innenseite von mindestens einer Seitenwand der Kammer (1) Hochfrequenz-Absorber (18) angebracht sind.

6. Vorrichtung nach einem der vorhergehenden Ansprüche,
**dadurch gekennzeichnet,**
**daß** die Verbindungsleitungen (15, 16) zwischen dem Symmetrierübertrager (14) und den Leitern (4, 6) der symmetrischen Doppelleitung in einem schmalen Raum der Kammer (1) angeordnet sind.

## Claims

1. Device for the EMC-testing of electrical equipment, comprising:
a) a chamber (1) made from a conductive material;
b) at least two conductors (4,6), which together form a symmetrical double line, arranged at opposite sides of the chamber (1) parallel to and at a relatively short distance (a) from the chamber walls (3,5); .
c) a high-frequency source (13), from which the two conductors (4,6) of the symmetrical double line are supplied in phase opposition at one end via a balun (14) and symmetrically to the chamber housing (1) as earth (M);
d) wherein the conductors (4,6) of the symmetrical double line are electrically connected at their other end via terminating resistors (11) to the chamber housing (1) and, together with the chamber walls (3,5) in each case, form asymmetrical lines.

2. Device according to claim 1,
**characterised in that**
the terminating resistors (11) are dimensioned in such a manner that they correspond to the surge impedance formed between the chamber walls (3,5) and the conductors (4, 6).

3. Device according to claim 1 or 2,
**characterised in that**
several conductors (Group 4 and Group 6 respectively) supplied in phase are arranged side by side on each side of the chamber (1) parallel to and at a distance from the chamber wall (3,5).

4. Device according to any one of claims 1 to 3,
**characterised in that**
the relative distances of the conductors (4, 6) and/or the terminating resistors (11) are dimensioned differently to provide a predetermined field-strength distribution.

5. Device according to any one of the preceding claims,
**characterised in that**
high-frequency absorbers (18) are fitted on the internal side of at least one side wall of the chamber (1).

6. Device according to any one of the preceding claims,
**characterised in that**
the connecting lines (15,16) between the balun (14) and the conductors (4,6) of the symmetrical double line are arranged in a narrow space of the chamber (1).

## Revendications

1. Dispositif pour tester la CEM d'appareils électriques, comprenant les éléments suivants:
a) une chambre (1) à base de matériau conducteur;
b) au moins deux conducteurs (4, 6) disposés sur des côtés opposés de la chambre (1) à la distance relativement faible (a) parallèlement aux parois de chambre (3, 5), qui forment ensemble une ligne double symétrique;
c) une source de haute fréquence (13), à partir de laquelle les conducteurs (4, 6) de la ligne double symétrique sont alimentés sur une extrémité au moyen d'un symétriseur (14) en phase opposée et de façon symétrique par rapport au boîtier de chambre (1) comme masse (M);
d) les conducteurs (4, 6) de la ligne double symétrique étant reliés électriquement sur leur autre extrémité au moyen de résistances terminales (11) au boîtier de chambre (1) et formant avec les parois de chambre (3, 5) respectivement des lignes dissymétriques.

2. Dispositif selon la revendication 1, **caractérisé en ce que** les résistances terminales (11) sont dimensionnées de telle sorte qu'elles correspondent à l'impédance caractéristique formée entre les parois de chambre (3, 5) et les conducteurs (4, 6).

3. Dispositif selon la revendication 1 ou 2, **caractérisé en ce que**, sur chaque côté de la chambre (1) et à distance parallèlement à la paroi de chambre (3, 5), sont disposés les uns à côté des autres à chaque fois plusieurs conducteurs alimentés en phases identiques (groupe 4 ou groupe 6).

4. Dispositif selon l'une quelconque des revendications 1 à 3, **caractérisé en ce que** les espacements réciproques des conducteurs (4, 6) et/ou les résistances terminales (11) sont dimensionnés différemment dans le sens d'une répartition d'intensité de chambre prédéfinie.

5. Dispositif selon l'une quelconque des revendications précédentes, **caractérisé en ce que** des absorbeurs de haute fréquence (18) sont placés sur le côté intérieur d'au moins une paroi latérale de la chambre (1).

6. Dispositif selon l'une quelconque des revendications précédentes, **caractérisé en ce que** les lignes de liaison (15, 16) sont disposées entre le symétriseur (14) et les conducteurs (4, 6) de la ligne double symétrique dans un espace étroit de la chambre (1).
